# EUROPEAN PATENT APPLICATION

(11) **EP 4 814 935 A1**
(43) Date of publication of application: **30.09.2026**
(21) Application number: 25749078.9
(22) Date of filing: 08.01.2025
(51) Int. Cl.: G09G 3/32, H10D 30/67

(54) **DISPLAY PANEL AND OPERATING METHOD THEREOF**

(30) Priority: 31.01.2024 KR 20240015183
(71) Applicant: Samsung Electronics Co., Ltd., Suwon-si, Gyeonggi-do 16677 (KR)
(72) Inventor: KIM, Kiwoo, Suwon-si, Gyeonggi-do 16677 (KR); SEOK, Seungwon, Suwon-si, Gyeonggi-do 16677 (KR); KEUM, Changmin, Suwon-si, Gyeonggi-do 16677 (KR)
(74) Representative: Gulde & Partner
(86) International application number: PCT/KR2025/000449
(87) International publication number: WO 2025/164991

(57) **Abstract**

Provided is a display panel comprising: a light-emitting element; a first transistor that controls a current flowing in the light-emitting element; a storage capacitor connected to a gate of the first transistor; a second transistor connected to a first terminal of the first transistor to apply a data signal; a third transistor connected to the gate and a second terminal of the first transistor; a fourth transistor connected to the second terminal of the first transistor to apply an initialization voltage; a fifth transistor connected to the first terminal of the first transistor to apply a first voltage; a sixth transistor connected to the second terminal of the first transistor and the light-emitting element; a seventh transistor connected to a first terminal of the storage capacitor to apply a reference voltage; and an eighth transistor connected to the first terminal of the storage capacitor to apply the first voltage.

## Description

### Technical Field

The present disclosure relates to a display panel and an operation method of the display panel.

### Background Art

Display panels using self-emissive elements such as micro light-emitting diodes (LEDs) or organic light-emitting diodes (OLEDs) may include pixel circuits for controlling current flowing through light-emitting elements.

A pixel circuit may include a light-emitting element, and a driving transistor for controlling current flowing through the light-emitting element. The current of the driving transistor is determined by a gate-source voltage V_{GS} and a threshold voltage Vth of the driving transistor.

However, due to non-uniformity of a manufacturing process (e.g., excimer laser annealing (ELA) or etching), threshold voltages of a plurality of driving transistors included in a display panel may be different from each other. In addition, when the current of a light-emitting element flows through a power supply wiring, a voltage drop (IR-drop) may occur due to a resistance component of the power supply wiring, and, due to the voltage drop, voltages applied to source nodes of the driving transistors may be different from each other according to their locations within a display panel.

Therefore, even when the same data voltage is input, current flowing through a light-emitting element may vary according to locations within a display panel, and, as a result, problems of the display panel, such as luminance non-uniformity, image sticking, and reduction in lifespan, may occur.

### Disclosure of Invention

### Solution to Problem

A display panel according to an embodiment of the present disclosure may include a light-emitting element, a first transistor configured to control a current flowing through the light-emitting element, a storage capacitor connected to a gate of the first transistor, a second transistor connected to a first terminal of the first transistor and configured to apply a data signal, a third transistor connected to the gate of the first transistor and a second terminal of the first transistor, a fourth transistor connected to the second terminal of the first transistor and configured to apply an initialization voltage, a fifth transistor connected to the first terminal of the first transistor and configured to apply a first voltage, a sixth transistor connected to the second terminal of the first transistor and the light-emitting element, a seventh transistor connected to a first terminal of the storage capacitor and configured to apply a reference voltage, and an eighth transistor connected to the first terminal of the storage capacitor and configured to apply the first voltage.

A display device according to an embodiment of the present disclosure may include an active area including a plurality of pixels arranged in rows and columns, a scan driver configured to apply a plurality of scan signals to the active area, an emission driver configured to apply a plurality of emission signals to the active area, a display driver integrated circuit (IC) configured to obtain image data, generate a plurality of data signals based on the image data, and apply the plurality of data signals to the active area, and a power supply configured to supply a first voltage, a second voltage, an initialization voltage, and a reference voltage to the active area.

In an embodiment of the present disclosure, each of the plurality of pixels may include a light-emitting element, a first transistor configured to control a current flowing through the light-emitting element, a storage capacitor connected to a gate of the first transistor, a second transistor connected to a first terminal of the first transistor and configured to apply a corresponding data signal, a third transistor connected to the gate of the first transistor and a second terminal of the first transistor, a fourth transistor connected to the second terminal of the first transistor and configured to apply an initialization voltage, a fifth transistor connected to the first terminal of the first transistor and configured to apply a first voltage, a sixth transistor connected to the second terminal of the first transistor and the light-emitting element, a seventh transistor connected to a first terminal of the storage capacitor and configured to apply a reference voltage, and an eighth transistor connected to the first terminal of the storage capacitor and configured to apply the first voltage.

### Brief Description of Drawings

FIG. 1 is a schematic diagram of a configuration of a display panel according to an embodiment of the present disclosure.
FIG. 2 illustrates a pixel circuit according to an embodiment of the present disclosure.
FIG. 3 is an operation timing diagram of a pixel circuit according to an embodiment of the present disclosure.
FIG. 4 illustrates a state of a pixel circuit in an initial period, according to an embodiment of the present disclosure.
FIG. 5 illustrates a state of a pixel circuit in a sampling period, according to an embodiment of the present disclosure.
FIG. 6 illustrates a state of a pixel circuit in an emission period, according to an embodiment of the present disclosure.
FIG. 7A illustrates a pixel circuit according to an embodiment of the present disclosure.
FIG. 7B is an operation timing diagram of a pixel circuit according to an embodiment of the present disclosure.
FIG. 8A illustrates a pixel circuit according to an embodiment of the present disclosure.
FIG. 8B is an operation timing diagram of a pixel circuit according to an embodiment of the present disclosure.
FIG. 9A illustrates a pixel circuit according to an embodiment of the present disclosure.
FIG. 9B is an operation timing diagram of a pixel circuit according to an embodiment of the present disclosure.
FIG. 10A illustrates a pixel circuit according to an embodiment of the present disclosure.
FIG. 10B is an operation timing diagram of a pixel circuit according to an embodiment of the present disclosure.

### Mode for the Invention

Throughout the disclosure, the expression "at least one of a, b and c" indicates only a, only b, only c, both a and b, both a and c, both b and c, all of a, b, and c, or variations thereof.

Although general terms widely used at present were selected for describing the disclosure in consideration of the functions thereof, these general terms may vary according to intentions of one of ordinary skill in the art, case precedents, the advent of new technologies, and the like. Terms arbitrarily selected by the applicant of the disclosure may also be used in a specific case. In this case, their meanings need to be given in the detailed description of the disclosure. Hence, the terms must be understood based on their meanings and the contents of the entire specification, not by simply stating the terms.

While such terms as "first," "second," etc., may be used to describe various components, such components must not be limited to the above terms. The above terms are used only to distinguish one component from another. For example, a first component discussed below could be termed a second component, and similarly, a second component may be termed a first component without departing from the teachings of embodiments.

When an element is referred to as being "connected to" or "coupled to" another element, it may be directly connected or coupled to the other element or intervening elements may be present. In contrast, when an element is referred to as being "directly connected to" or "directly coupled to" another element, there are no intervening elements present.

An expression used in the singular may encompass the expression of the plural, unless it has a clearly different meaning in the context. Unless otherwise defined, all terms (including technical and scientific terms) used herein have the same meaning as commonly understood by one of ordinary skill in the art to which this disclosure belongs.

In the present disclosure, it is to be understood that the terms such as "including", "having", and "comprising" are intended to indicate the existence of the features, numbers, steps, actions, components, parts, or combinations thereof disclosed in the disclosure, and are not intended to preclude the possibility that one or more other features, numbers, steps, actions, components, parts, or combinations thereof may exist or may be added.

Regarding a component represented as a "portion (unit)" or a "module" used herein, two or more components may be combined into one component or one component may be divided into two or more components according to subdivided functions. In addition, each component described hereinafter may additionally perform some or all of functions performed by another component, in addition to main functions of itself, and some of the main functions of each component may be performed entirely by another component.

In the present disclosure, a machine-readable storage medium may be provided in the form of a non-transitory storage medium. The 'non-transitory storage medium' is a tangible device and only means that it does not contain a signal (e.g., electromagnetic waves). This term does not distinguish a case in which data is stored semi-permanently in a storage medium from a case in which data is temporarily stored. For example, the non-transitory storage medium may include a buffer in which data is temporarily stored.

According to an embodiment, methods according to various aspects of the present disclosure may be provided by being included in a computer program product. The computer program product, which is a commodity, may be traded between sellers and buyers. Computer program products are distributed in the form of machine-readable storage media (e.g., compact disc read only memory (CD-ROM)), or may be distributed (e.g., downloaded or uploaded) through an application store or between two user devices (e.g., smartphones) directly and online. In the case of online distribution, at least a portion of the computer program product (e.g., a downloadable app) may be stored at least temporarily in a machine-readable storage medium, such as a memory of a manufacturer's server, a server of an application store, or a relay server, or may be temporarily generated.

Embodiments of the present disclosure will now be described in detail with reference to the accompanying drawings so that this disclosure may be easily performed by one of ordinary skill in the art to which the present disclosure pertains. The present disclosure may, however, be embodied in many different forms and should not be construed as being limited to the embodiments set forth herein.

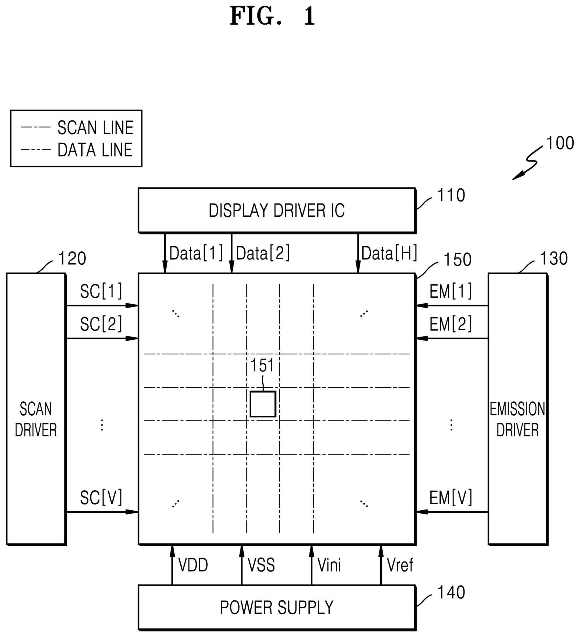

FIG. 1 is a schematic diagram of a configuration of a display panel 100 according to an embodiment of the present disclosure.

Referring to FIG. 1, the display panel 100 according to an embodiment of the present disclosure may include a display driver integrated circuit (IC) (DDI) 110, a scan driver 120, an emission driver 130, a power supply 140, and an active area 150. However, a structure of the display panel 100 is not limited thereto. For example, the display panel 100 may further include a timing controller for matching a signal received from the outside with an operation timing of the display panel 100, or a digital-to-analog converter for converting a digital signal into an analog signal.

A display device according to an embodiment of the present disclosure may include the display panel 100.

The display device according to an embodiment of the present disclosure may include the display driver IC (DDI) 110, the scan driver 120, the emission driver 130, the power supply 140, and the active area 150. However, a configuration of the display device is not limited thereto. For example, the display device may further include a timing controller for matching a signal received from the outside with an operation timing of the display panel 100, or a digital-to-analog converter for converting a digital signal into an analog signal.

In an embodiment of the present disclosure, the display driver IC 110 may generate a plurality of data signals Data[1] through Data[H], based on image data obtained from an external processor (e.g., an application processor (AP) or a graphics processing unit (GPU)), and apply the generated plurality of data signals Data[1] through Data[H] to a plurality of data lines included in the active area 150. In an embodiment, the plurality of data signals Data[1] through Data[H] may be voltages corresponding to respective brightnesses of pixels 151 included in the active area 150.

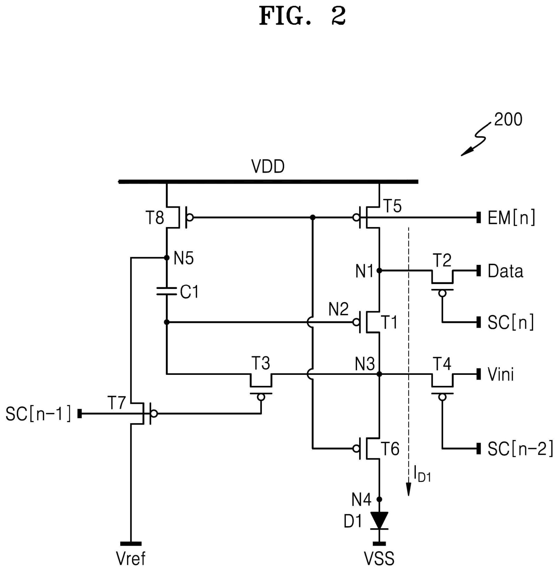

In an embodiment of the present disclosure, the scan driver 120 may apply scan signals SC[1] through SC[V] to a plurality of scan (SC) lines included in the active area 150. In an embodiment of the present disclosure, the scan signals SC[1] through SC[V] may be voltages for turning on or off corresponding transistors respectively included in the pixels 151. An operation of each pixel 151 according to the scan signals SC[1] through SC[V] will be described later with reference to FIGS. 2 through 6.

In an embodiment of the present disclosure, the scan driver 130 may apply emission signals EM[1] through EM[V] allowing the plurality of pixels 151 included in the active area 150 to emit light. In an embodiment of the present disclosure, the emission signals EM[1] through EM[V] may be voltages for turning on or off corresponding transistors respectively included in the pixels 151. An operation of each pixel 151 according to the emission signals EM[1] through EM[V] will be described later with reference to FIGS. 2 through 6.

In an embodiment of the present disclosure, the power supply 140 may supply a first voltage VDD, a second voltage VSS, an initialization voltage Vini, and a reference voltage Vref to the active area 150. In an embodiment of the disclosure, the first voltage VDD may be a voltage of a higher potential than the second voltage VSS. An operation of each pixel 151 according to the first voltage VDD, the second voltage VSS, the initialization voltage Vini, and the reference voltage Vref will be described later with reference to FIGS. 2 through 6.

In an embodiment of the present disclosure, the active area 150 may include the plurality of pixels 151, the plurality of SC lines (as indicated by one-dot-dashed lines in FIG. 1), and the plurality of data lines (as indicated by two-dot dashed lines in FIG. 1). However, a structure of the active area 150 is not limited thereto. For example, the active area 150 may further include a plurality of power supply lines for applying the first voltage VDD, the second voltage VSS, the initialization voltage Vini, and the reference voltage Vref supplied from the power supply 140 to the pixels 151.

In an embodiment of the present disclosure, SC lines may be disposed in each row. The SC lines are lines for applying the scan signals SC[1] through SC[V] to the pixels 151. For example, a number of SC lines that is the same number as a vertical resolution may be arranged in the active area 150.

In an embodiment of the present disclosure, data lines may be disposed in each column. The data lines are lines for applying the data signals Data[1] through Data[H] to the pixels 151. For example, a number of data lines that is the same number as a horizontal resolution may be arranged in the active area 150. Alternatively, when each pixel includes three subpixels, horizontal resolution × 3 data lines may be disposed in the active area 150. When a multiplexer (MUX) for selecting some of the plurality of data signals is used, a smaller number of data lines may be disposed in the active area 150.

In an embodiment of the present disclosure, the pixels 151 may be disposed at intersections between the SC lines and the data lines.

In an embodiment of the present disclosure, the pixel 151 may include a light-emitting element that emits light on its own when current flows therethrough, and a driving transistor configured to control the current flowing through the light-emitting element. The driving transistor may be turned on or off in response to a corresponding data signal to control the current flowing through the light-emitting element.

In an embodiment of the present disclosure, the pixel 151 may include a plurality of subpixels (not shown). For example, the pixel 151 may include three subpixels respectively corresponding to red (R), green (G), and blue (B).

FIG. 2 illustrates a pixel circuit 200 according to an embodiment of the present disclosure.

The pixel circuit 200 shown in FIG. 2 may be included in the pixel 151 (see FIG. 1) corresponding to an n-th row and an m-th column of the active area 150 (see FIG. 1). Here, n is an arbitrary natural number between 1 and a vertical resolution V, and m is an arbitrary natural number between 1 and a horizontal resolution H.

In an embodiment of the present disclosure, the pixel circuit 200 may include a light-emitting element D1, first, second, third, fourth, fifth, sixth, seventh, and eighth transistors T1, T2, T3, T4, T5, T6, T7, and T8, and a storage capacitor C1.

In an embodiment of the present disclosure, the light-emitting element D1 may emit light proportional to a magnitude of a current when the current flows. For example, the light-emitting element D1 may be a self-emissive element such as a micro light-emitting diode (LED) or an organic light-emitting diode (OLED).

In an embodiment of the present disclosure, the first through eighth transistors T1 through T8 may be turned on or off in response to a first scan signal SC[n-2], a second scan signal SC[n-1], a third scan signal SC[n], and an emission signal EM[n]. In an embodiment, the first scan signal SC[n-2] may be a scan signal applied to an (n-2)th scan line, the second scan signal SC[n-1] may be a scan signal applied to an (n-1)th scan line, and the third scan signal SC[n] may be a scan signal applied to an n-th scan line. In an embodiment, the first, second, and third scan signals SC[n-2], SC[n-1], and SC[n] may be generated by the scan driver 120 of FIG. 1. As described later, a voltage of each node in the pixel circuit 200 may change according to states (i.e., on or off) of the first through eighth transistors T1 through T8, and a current of the light-emitting element D1 may change.

In an embodiment of the present disclosure, the first through eighth transistors T1 through T8 may each be a low-temperature polycrystalline silicon thin-film transistor (LTPS TFT), an oxide thin-film transistor (TFT), a low-temperature polycrystalline oxide (LTPO), or a silicon-based switching element.

In FIGS. 2 through 6, the first through eighth transistors T1 through T8 are illustrated as being P-type transistors. However, this is only an example, and the first through eighth transistors T1 through T8 may be N-type transistors. In the following description, a first terminal of each of the first through eighth transistors T1 through T8 may be a source, and a second terminal thereof may be a drain. However, the present disclosure is not limited thereto, and, when types of the first through eighth transistors T1 through T8 change, the first terminals and the second terminals may also change.

In an embodiment of the present disclosure, a gate of the first transistor T1 may be connected to a second terminal of the storage capacitor C1 and a first terminal of the third transistor T3.

In an embodiment of the present disclosure, the first terminal (node N1) of the first transistor T1 may be connected to a second terminal of the second transistor T2 and a second terminal of the fifth transistor T5, and a second terminal (node N3) of the first transistor T1 may be connected to a second terminal of the third transistor T3, a first terminal of the fourth transistor T4, and a first terminal of the sixth transistor T6.

In an embodiment of the present disclosure, the first transistor T1 may be a driving transistor. When the fifth transistor T5, the first transistor T1, and the sixth transistor T6 are turned on, a current I_{D1} may flow through a path including the first voltage VDD, the fifth transistor T5, the first transistor T1, the sixth transistor T6, the light-emitting element D1, and the second voltage VSS. In this case, the current I_{D1} may be determined according to a gate-source voltage V_{GS} and a threshold voltage Vth of the first transistor T1 as in Equation 1. ${I}_{D 1} = \frac{1}{2} {μC}_{OX} \frac{W}{L} {\left(\left|{V}_{GS}\right|-\left|Vth\right|\right)}^{2}$

When the fifth transistor T5 is turned on, the first voltage VDD is applied to the source of the first transistor T1, and thus the current I_{D1} may be calculated using Equation 2. ${I}_{D 1} = \frac{1}{2} {μC}_{OX} \frac{W}{L} {\left(\left|{V}_{GS}-VDD\right|-\left|Vth\right|\right)}^{2}$

In Equations 1 and 2, µ is a mobility of a carrier, Cₒₓ is a capacitance of an oxide layer of the first transistor T1, and W and L are a width and a length of a channel formed in the first transistor T1, respectively.

Referring to Equation 2, a magnitude of the current I_{D1} may change according to the first voltage VDD and the threshold voltage Vth of the first transistor T1.

However, when the current I_{D1} flows, a voltage drop may occur due to a resistance component of a power supply line, and, due to the voltage drop, the first voltage VDD applied to a source of the first transistor T1 may change according to locations within the display panel 100. Due to non-uniformity of a process, the threshold voltage Vth of the first transistor T1 may be different for each pixel 151 of FIG. 1. As a result, luminance may be non-uniform according to locations within a display panel due to deviations in a voltage drop and a threshold voltage.

According to an embodiment of the present disclosure, the pixel circuit 200 may remove influences of the first voltage VDD and the threshold voltage Vth on the current I_{D1} by simultaneously compensating for a voltage drop (IR-drop) occurring when the current I_{D1} flows and the threshold voltage Vth of the first transistor T1 for each pixel 151 according to an operation to be described later.

In an embodiment of the present disclosure, a gate of the second transistor T2 may be connected to an n-th scan line. The third scan signal SC[n] may be applied to a gate of the second transistor T2, and the second transistor T2 may be turned on or off in response to the third scan signal SC[n]. For example, the second transistor T2 may be turned on when the third scan signal SC[n] is low, and may be turned off when the third scan signal SC[n] is high.

In an embodiment of the present disclosure, a first terminal of the second transistor T2 may be connected to a data line, and a second terminal of the second transistor T2 may be connected to the first terminal of the first transistor T1 and the second terminal of the fifth transistor T5. When the second transistor T2 is turned on, a data signal may be applied to the node N1. The second transistor T2 may be referred to as a switching transistor configured to apply the data signal to the driving transistor.

In an embodiment of the present disclosure, a gate of the third transistor T3 may be connected to an (n-1)th scan line. The second scan signal SC[n-1] may be applied to the gate of the third transistor T3, and the third transistor T3 may be turned on or off in response to the second scan signal SC[n-1]. For example, the third transistor T3 may be turned on when the second scan signal SC[n-1] is low, and may be turned off when the second scan signal SC[n-1] is high.

In an embodiment of the present disclosure, the first terminal of the third transistor T3 may be connected to the gate of the first transistor T1 and the second terminal of the storage capacitor C1, and the second terminal of the third transistor T3 may be connected to the second terminal of the first transistor T1, the first terminal of the fourth transistor T4, and the first terminal of the sixth transistor T6. When the third transistor T3 and the fourth transistor T4 are turned on, the initialization voltage Vini may be applied to the gate of the first transistor T1.

In an embodiment of the present disclosure, a gate of the fourth transistor T4 may be connected to an (n-2)th scan line. The first scan signal SC[n-2] may be applied to the gate of the fourth transistor T4, and the fourth transistor T4 may be turned on or off in response to the first scan signal SC[n-2]. For example, the fourth transistor T4 may be turned on when the first scan signal SC[n-2] is low, and may be turned off when the first scan signal SC[n-2] is high.

In an embodiment of the present disclosure, the first terminal of the fourth transistor T4 may be connected to the second terminal of the first transistor T1, the second terminal of the third transistor T3, and the first terminal of the sixth transistor T6, and the second terminal of the fourth transistor T4 may be connected to a power supply line that supplies the initialization voltage Vini. When the third transistor T3 and the fourth transistor T4 are turned on, the initialization voltage Vini may be applied to the gate of the first transistor T1.

In an embodiment of the present disclosure, a gate of the fifth transistor T5 may be connected to a line for applying the emission signal EM[n]. The emission signal EM[n] may be applied to the gate of the fifth transistor T5, and the fifth transistor T5 may be turned on or off in response to the emission signal EM[n]. For example, the fifth transistor T5 may be turned on when the emission signal EM[n] is low, and may be turned off when the emission signal EM[n] is high.

In an embodiment of the present disclosure, the first terminal of the fifth transistor T5 may be connected to a power supply line that supplies the first voltage VDD, and the second terminal of the fifth transistor T5 may be connected to the first terminal of the first transistor T1 and the second terminal of the second transistor T2. When the fifth transistor T5 is turned off, the current I_{D1} does not flow.

In an embodiment of the present disclosure, a gate of the sixth transistor T6 may be connected to a line for applying the emission signal EM[n]. The emission signal EM[n] may be applied to the gate of the sixth transistor T6, and the six transistor T6 may be turned on or off in response to the emission signal EM[n]. For example, the sixth transistor T6 may be turned on when the emission signal EM[n] is low, and may be turned off when the emission signal EM[n] is high.

In an embodiment of the present disclosure, the first terminal of the sixth transistor T6 may be connected to the second terminal of the first transistor T1, the second terminal of the third transistor T3, and the first terminal of the fourth transistor T4, and the second terminal (node N4) of the sixth transistor T6 may be connected to an anode of the light-emitting element D1. When the sixth transistor T6 is turned off, the current I_{D1} does not flow.

In an embodiment of the present disclosure, a gate of the seventh transistor T7 may be connected to the (n-1)th scan line. The second scan signal SC[n-1] may be applied to a gate of the seventh transistor T7, and the seventh transistor T7 may be turned on or off in response to the second scan signal SC[n-1]. For example, the seventh transistor T7 may be turned on when the second scan signal SC[n-1] is low, and may be turned off when the second scan signal SC[n-1] is high.

In an embodiment of the present disclosure, the first terminal of the seventh transistor T7 may be connected to a power supply line that supplies the reference voltage Vref, and the second terminal of the seventh transistor T7 may be connected to the first terminal (node N5) of the storage capacitor C1 and the second terminal of the eighth transistor T8. When the seventh transistor T7 is turned on, the reference voltage Vref is applied to the first terminal (node N5) of the storage capacitor C1.

In an embodiment of the present disclosure, a gate of the eighth transistor T8 may be connected to a line for applying the emission signal EM[n]. The emission signal EM[n] may be applied to a gate of the eighth transistor T8, and the eighth transistor T8 may be turned on or off in response to the emission signal EM[n]. For example, the eighth transistor T8 may be turned on when the emission signal EM[n] is low, and may be turned off when the emission signal EM[n] is high.

In an embodiment of the present disclosure, the first terminal of the eighth transistor T8 may be connected to a power supply line that supplies the first voltage VDD, and the second terminal of the eighth transistor T8 may be connected to the first terminal (node N5) of the storage capacitor C1 and the second terminal of the seventh transistor T7. When the eighth transistor T8 is turned on, the first voltage VDD may be applied to the first terminal (node N5) of the storage capacitor C1.

Referring to FIGS. 1 and 2, the display panel 100 according to an embodiment of the present disclosure may include two gate in panel (GIP) drivers (i.e., the scan driver 120 and the emission driver 130) to control the pixels 151. As the display panel 100 includes fewer GIP drivers, an aperture ratio may increase, production costs may be reduced, a size of a bezel may be reduced, and power consumption may be reduced. Therefore, the display panel 100 according to an embodiment of the present disclosure may have the aforementioned advantages compared with other display panels including three or more GIP drivers to simultaneously compensate for a voltage drop occurring when the current I_{D1} flows and the threshold voltage Vth of the driving transistor.

In the display panel 100 according to an embodiment of the present disclosure, one transistor (i.e., the third transistor T3) is connected to the gate of the first transistor T1, which is a driving transistor. As the number of transistors connected to the gate of the driving transistor increases, a leakage current flowing through the transistors increases. In detail, during driving at a low refresh rate (e.g., 1Hz or 10Hz) to reduce power consumption, the leakage current becomes larger, and a storage capacitor is rapidly discharged due to the leakage current, so that a flicker phenomenon may occur in the display panel 100. Therefore, the display panel 100 according to an embodiment of the present disclosure may reduce the flicker phenomenon compared with other display panels in which two or more transistors are connected to a gate of a driving transistor.

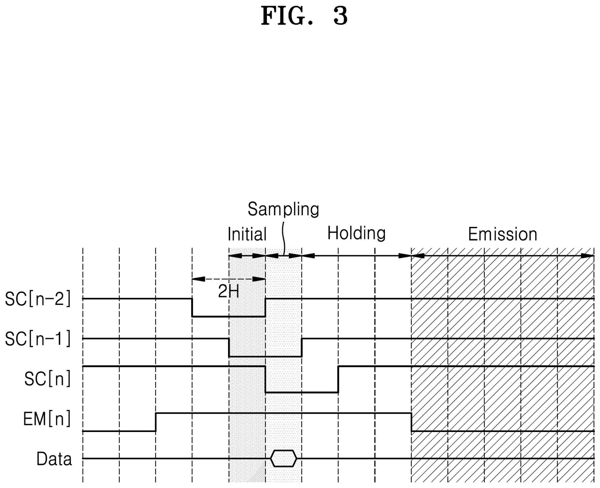

FIG. 3 is an operation timing diagram of the pixel circuit 200 of FIG. 2 according to an embodiment of the present disclosure.

In an embodiment of the present disclosure, the pixel circuit 200 of FIG. 2 may operate in an initial period, a sampling period, and an emission period. In an embodiment of the present disclosure, a holding period may be added between the sampling period and the emission period. In the present disclosure, the initial period may be referred to as a first operation period. In the present disclosure, the sampling period may be referred to as a second operation period. In the present disclosure, the emission period may be referred to as a third operation period.

These operation periods may be distinguished from each other by the first, second, and third scan signals SC[n-2], SC[n-1], and SC[n] or the emission signal EM[n]. In an embodiment of the present disclosure, in the initial period, the first scan signal SC[n-2] and the second scan signal SC[n-1] may each be a first value for turning on a transistor. In an embodiment of the present disclosure, in the sampling period, the second scan signal SC[n-1] and the third scan signal SC[n] may each be a first value for turning on a transistor. In an embodiment of the present disclosure, in the emission period, the first, second, and third scan signals SC[n-2], SC[n-1], and SC[n] may each be a second value for turning off a transistor, and the emission signal EM[n] may be a first value for turning on a transistor. The first value may be low and the second value may be high.

As shown in FIG. 3, in an embodiment of the present disclosure, the first, second, and third scan signals SC[n-2], SC[n-1], and SC[n] may each be a first value for turning on a transistor for at least 2H (horizontal time) during the entire operation period. For example, the first scan signal SC[n-2] and the second scan signal SC[n-1] may change from the second value to the first value with a time difference of 1H, and may each maintain the first value for 2H. The second scan signal SC[n-1] and the third scan signal SC[n] may change from the second value to the first value with a time difference of 1H, and may each maintain the first value for 2H. Therefore, the initial period and the sampling period may be maintained for at least 1H.

Here, 1H may include an input time of data that is allocated to one pixel line to express one frame. In an embodiment of the present disclosure, 1H may be determined based on a refresh rate and a vertical resolution of a display. For example, 1H may be determined by dividing the time of one frame (i.e., 1/refresh rate) by the vertical resolution of the display.

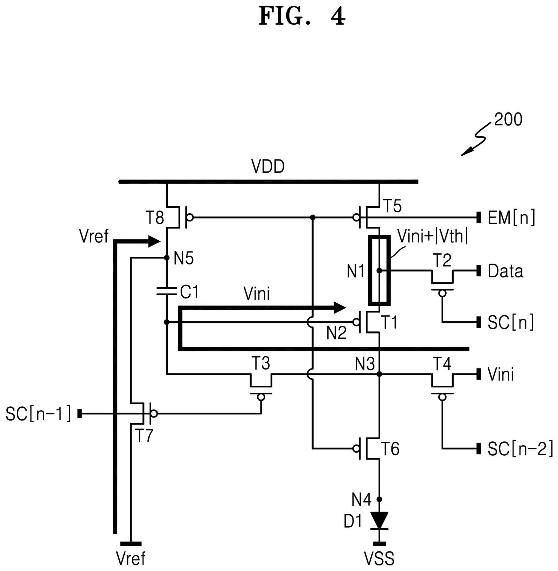

A state and operation of the pixel circuit 200 in each operation period will now be described with reference to FIGS. 4 through 6.

FIG. 4 illustrates a state of the pixel circuit 200 in the initial period, according to an embodiment of the present disclosure.

In an embodiment of the present disclosure, the initial period is a period for initializing a gate voltage of a driving transistor (i.e., the first transistor T1). In the initial period, the first scan signal SC[n-2] and the second scan signal SC[n-1] may each be a first value for turning on a transistor.

Referring to FIG. 4, in the initial period, the fourth transistor T4 may be turned on in response to the first scan signal SC[n-2] being the first value (e.g., low), and the third transistor T3 and the seventh transistor T7 may be turned on in response to the second scan signal SC[n-1] being the first value (e.g., low).

When the third transistor T3, the fourth transistor T4, and the seventh transistor T7 are turned on, the gate (node N2) voltage of the first transistor T1 may be initialized to the initialization voltage Vini through the third transistor T3 and the fourth transistor T4, and a source (node N1) voltage of the first transistor T1 may become a third voltage. In an embodiment, the third voltage may be determined based on an initialization voltage and a threshold voltage. For example, the third voltage may be a voltage higher than the initialization voltage Vini by an absolute value of the threshold voltage (i.e., may be Vini + |Vth|). The reference voltage Vref may be applied to the first terminal (node N5) of the storage capacitor C1.

In the display panel 100 according to an embodiment of the present disclosure, because the source of the driving transistor (i.e., the first transistor T1) is not floating but a specific voltage (i.e., Vini + |Vth|) is applied to the source in the initial period, an influence of a previous frame on a current frame may be minimized, thereby addressing motion blur caused by hysteresis of the driving transistor.

FIG. 4 illustrates a state of the pixel circuit 200 in the sampling period, according to an embodiment of the present disclosure.

In an embodiment, the sampling period is a period in which a data signal is applied to the pixel circuit 200 and the threshold voltage Vth of the driving transistor is sampled. In the sampling period, the second scan signal SC[n-1] and the third scan signal SC[n] may each be a first value for turning on a transistor.

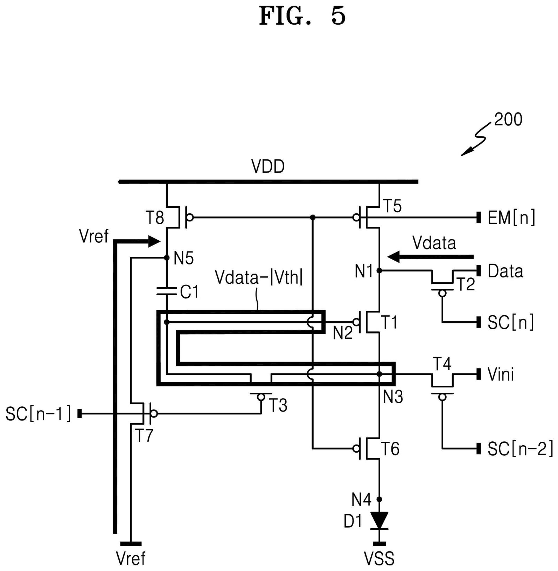

Referring to FIG. 5, in the sampling period, the third transistor T3 and the seventh transistor T7 may be turned on in response to the second scan signal SC[n-1] being the first value (e.g., low), and the second transistor T2 may be turned on in response to the third scan signal SC[n] being the first value (e.g., low).

When the second transistor T2, the third transistor T3, and the seventh transistor T7 are turned on, a data signal Vdata may be applied to the source of the first transistor T1, and the gate voltage of the first transistor T1 may become a fourth voltage. In an embodiment, the fourth voltage may be determined based on the data signal Vdata and the threshold voltage. For example, the fourth voltage may be a voltage lower than the data signal Vdata by the absolute value of the threshold voltage (i.e., may be Vdata - |Vth|). The first terminal (node N5) of the storage capacitor C1 may be maintained as the reference voltage Vref.

In the sampling period, a threshold voltage Vth component may be included in a gate voltage V_{G} of the driving transistor. Therefore, as described later, a threshold voltage component may be canceled from the current I_{D1} in the emission period.

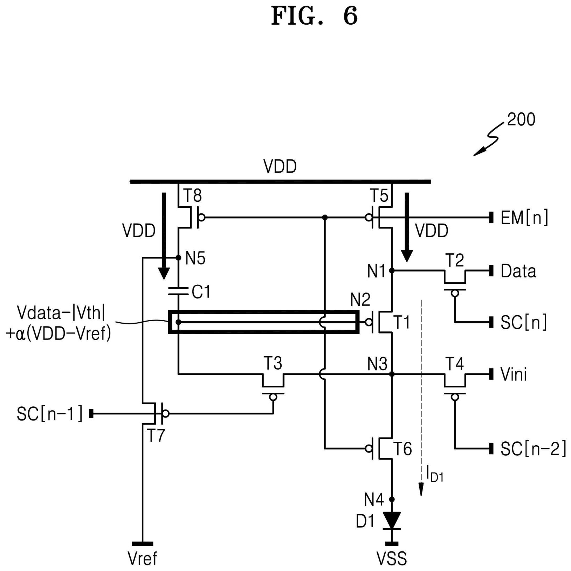

FIG. 6 illustrates a state of the pixel circuit 200 in the emission period, according to an embodiment of the present disclosure.

In an embodiment, the emission period is a period in which the current I_{D1} flows through the light-emitting element D1 and the light-emitting element D1 emits light. In the emission period, the first, second, and third scan signals SC[n-2], SC[n-1], and SC[n] may each be a second value for turning off a transistor, and the emission signal EM[n] may be a first value for turning on a transistor.

Referring to FIG. 6, in the emission period, the fifth transistor T5, the sixth transistor T6, and the eighth transistor T8 may be turned on in response to the emission signal EM[n] being the first value (e.g., low).

When the fifth transistor T5, the sixth transistor T6, and the eighth transistor T8 are turned on, a voltage of the first terminal (node N5) of the storage capacitor C1 may change from the reference voltage Vref to the first voltage VDD, and the source voltage of the first transistor T1 may become the first voltage VDD.

When the voltage of the first terminal (node N5) of the storage capacitor C1 changes instantaneously, a voltage of the second terminal (i.e., the gate of the first transistor T1) of the storage capacitor C1 changes in proportion to a variation in the voltage of the first terminal (i.e., VDD-Vref) due to a coupling phenomenon. As a result, the gate voltage V_{G} of the first transistor T1 in the emission period may be calculated using Equation 3. ${V}_{G} = Vdata - \left|Vth\right| + α \left(VDD-Vref\right)$ where α is C1 / (C1 + Cpara), and Cpara is a parasitic capacitance generated at the first terminal of the storage capacitor C1. The parasitic capacitance may be generated by a layout of the pixel circuit 200. Because Cpara is very small compared to C1, α may be approximated to 1. In the present disclosure, α(VDD-Vref) may be referred to as a fifth voltage.

By substituting Equation 3 into Equation 2, the current I_{D1} as in Equation 4 flows through the light-emitting element D1. $\begin{matrix}{I}_{D 1} = \frac{1}{2} {μC}_{OX} \frac{W}{L} {\left(\left|Vth\right|-Vdata+\left(1-α\right)VDD+αVref-\left|Vth\right|\right)}^{2} \\ = \frac{1}{2} {μC}_{OX} \frac{W}{L} {\left(-Vdata+\left(1-α\right)VDD+αVref\right)}^{2}\end{matrix}$

When α is approximated to 1 in Equation 4, the current I_{D1} may be calculated using Equation 5. ${I}_{D 1} ≒ \frac{1}{2} {μC}_{OX} \frac{W}{L} {\left(Vref-Vdata\right)}^{2}$

Referring to Equation 5, because the current I_{D1} of the light-emitting element D1 does not include the first voltage VDD and the threshold voltage Vth component, the display panel 100 according to an embodiment of the present disclosure may simultaneously compensate for a voltage drop (IR-drop) occurring when the current I_{D1} flows and the threshold voltage Vth of the first transistor T1 for each pixel 151 of FIG. 1.

Meanwhile, there is a case where the storage capacitor C1 is short-circuited due to foreign substances during a process of manufacturing a display. When the storage capacitor C1 is short-circuited, a defect rate of the display may vary according to a state (i.e., on or off) of the driving transistor. When the driving transistor is turned on, a corresponding pixel may become a bright spot, and, when the driving transistor is turned off, the corresponding pixel may become a black spot. To reduce the defect rate of the display, the driving transistor needs to be turned off so that the corresponding pixel becomes a black spot even when the storage capacitor C1 is short-circuited.

As described above, in the display panel 100 according to an embodiment of the present disclosure, the voltage of the first terminal (node N5) of the storage capacitor C1 may be VDD and the source voltage of the driving transistor (i.e., the first transistor T1) may be VDD, in the emission period. Therefore, even when the storage capacitor C1 is short-circuited, the gate voltage of the first transistor T1 becomes VDD, so that the first transistor T1 may maintain an off state and a corresponding pixel may become a black spot. As a result, the display panel 100 according to an embodiment of the present disclosure may have a lower defect rate even when the storage capacitor C1 is short-circuited due to foreign substances or the like during the manufacturing process.

The pixel circuit 200 according to an embodiment of the present disclosure described above may operate using only two GIP drivers (i.e., a scan driver and an emission driver), and may simultaneously compensate for the voltage drop (IR-drop) occurring when the current I_{D1} flows and the threshold voltage Vth of the first transistor T1 for each pixel 151 of FIG. 1. A pixel circuit capable of simultaneously compensating for a voltage drop and a threshold voltage by using only two GIP drivers similar to the pixel circuit 200 will now be described.

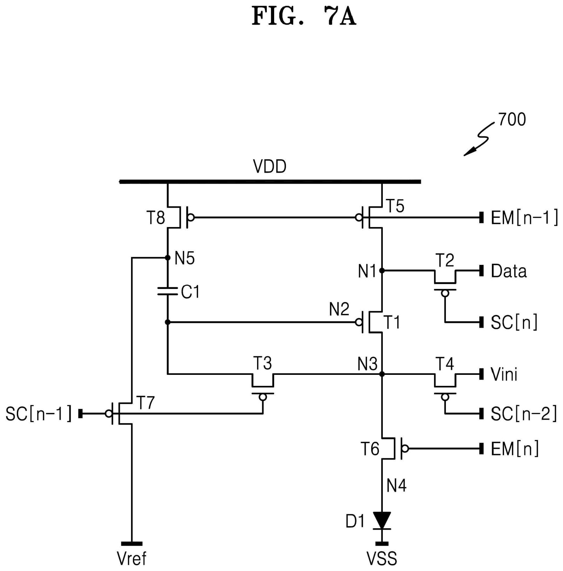

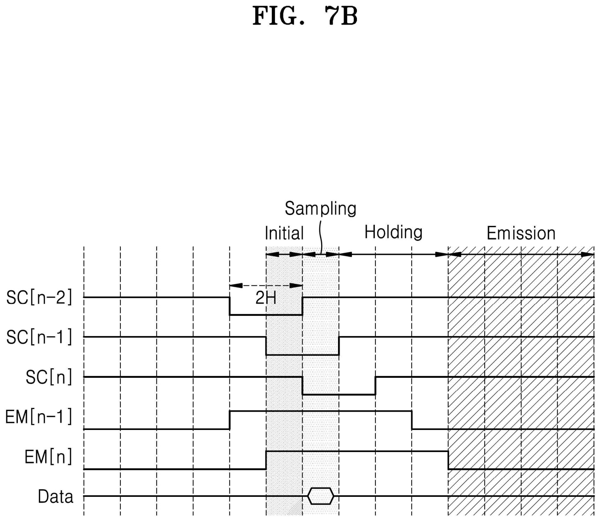

FIG. 7A illustrates a pixel circuit 700 according to an embodiment of the present disclosure, and FIG. 7B is an operation timing diagram of the pixel circuit 700 according to an embodiment of the present disclosure.

Referring to FIG. 7A, in an embodiment of the present disclosure, the pixel circuit 700 may include a light-emitting element D1, first, second, third, fourth, fifth, sixth, seventh, and eighth transistors T1, T2, T3, T4, T5, T6, T7, and T8, and a storage capacitor C1. In an embodiment of the present disclosure, the first through eighth transistors T1 through T8 may be turned on or off in response to a first scan signal SC[n-2], a second scan signal SC[n-1], a third scan signal SC[n], and a first emission signal EM[n-1], and a second emission signal EM[n].

A connection state between the light emitting element D1, the first through eighth transistors T1 through T8, and the storage capacitor C1 included in the pixel circuit 700 is the same as that of the pixel circuit 200 of FIG. 2. However, in the pixel circuit 700, the fifth transistor T5 and the eighth transistor T8 may be turned on or off in response to the first emission signal EM[n-1], and the sixth transistor T6 may be turned on or off in response to the second emission signal EM[n].

Referring to FIG. 7B, in an embodiment of the present disclosure, the pixel circuit 700 may operate in an initial period, a sampling period, and an emission period. In an embodiment of the present disclosure, a holding period may be added between the sampling period and the emission period.

These operation periods may be distinguished from each other by the first, second, and third scan signals SC[n-2], SC[n-1], and SC[n] or the first and second emission signals EM[n-1] and EM[n].

In an embodiment, in the initial period, the first scan signal SC[n-2] and the second scan signal SC[n-1] may each be a first value for turning on a transistor. The fourth transistor T4 may be turned on in response to the first scan signal SC[n-2] being the first value, and the third transistor T3 and the seventh transistor T7 may be turned on in response to the second scan signal SC[n-1] being the first value.

In an embodiment of the present disclosure, in the sampling period, the second scan signal SC[n-1] and the third scan signal SC[n] may be a first value for turning on a transistor. The third transistor T3 and the seventh transistor T7 may be turned on in response to the second scan signal SC[n-1] being the first value, and the second transistor T2 may be turned on in response to the third scan signal SC[n] being the first value.

In an embodiment of the present disclosure, in the emission period, the first, second, and third scan signals SC[n-2], SC[n-1], and SC[n] may each be a second value for turning off a transistor, and the first and second emission signals EM[n-1] and EM[n] may be a first value for turning on a transistor. The fifth transistor T5 and the eighth transistor T8 may be turned on in response to the first emission signal EM[n-1] being the first value, and the sixth transistor T6 may be turned on in response to the second emission signal EM[n] being the first value.

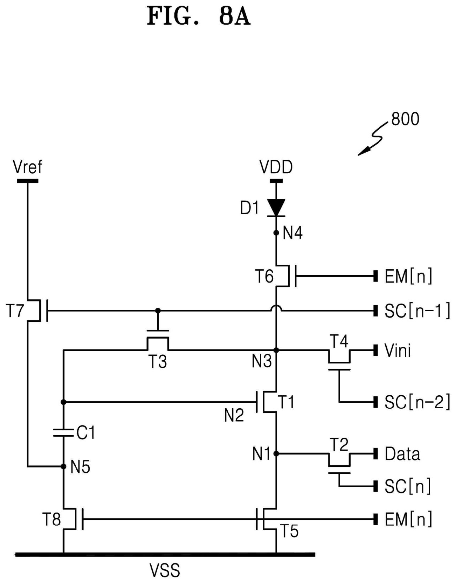

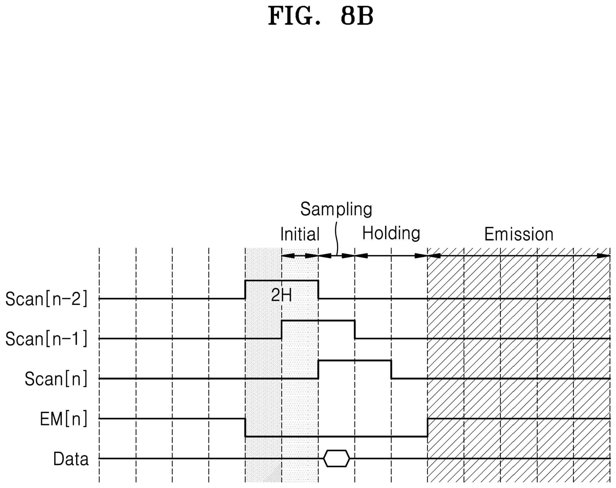

FIG. 8A illustrates a pixel circuit 800 according to an embodiment of the present disclosure, and FIG. 8B is an operation timing diagram of the pixel circuit 800 according to an embodiment of the present disclosure.

Referring to FIG. 8A, in an embodiment of the present disclosure, the pixel circuit 800 may include a light-emitting element D1, first, second, third, fourth, fifth, sixth, seventh, and eighth transistors T1, T2, T3, T4, T5, T6, T7, and T8, and a storage capacitor C1. In an embodiment of the present disclosure, the first through eighth transistors T1 through T8 may be turned on or off in response to a first scan signal SC[n-2], a second scan signal SC[n-1], a third scan signal SC[n], and an emission signal EM[n]. The first through eighth transistors T1 through T8 included in the pixel circuit 800 may be N-type transistors.

Referring to FIG. 8B, in an embodiment of the present disclosure, the pixel circuit 800 may operate in an initial period, a sampling period, and an emission period. In an embodiment of the present disclosure, a holding period may be added between the sampling period and the emission period.

These operation periods may be distinguished from each other by the first, second, and third scan signals SC[n-2], SC[n-1], and SC[n] or the emission signal EM[n].

In an embodiment of the present disclosure, in the initial period, the first scan signal SC[n-2] and the second scan signal SC[n-1] may each be a first value for turning on a transistor. The fourth transistor T4 may be turned on in response to the first scan signal SC[n-2] being the first value, and the third transistor T3 and the seventh transistor T7 may be turned on in response to the second scan signal SC[n-1] being the first value.

In an embodiment of the present disclosure, in the sampling period, the second scan signal SC[n-1] and the third scan signal SC[n] may each be a first value for turning on a transistor. The third transistor T3 and the seventh transistor T7 may be turned on in response to the second scan signal SC[n-1] being the first value, and the second transistor T2 may be turned on in response to the third scan signal SC[n] being the first value.

In an embodiment of the present disclosure, in the emission period, the first, second, and third scan signals SC[n-2], SC[n-1], and SC[n] may each be a second value for turning off a transistor, and the emission signal EM[n] may be a first value for turning on a transistor. The fifth transistor T5, the sixth transistor T6, and the eighth transistor T8 may be turned on in response to the emission signal EM[n] being the first value.

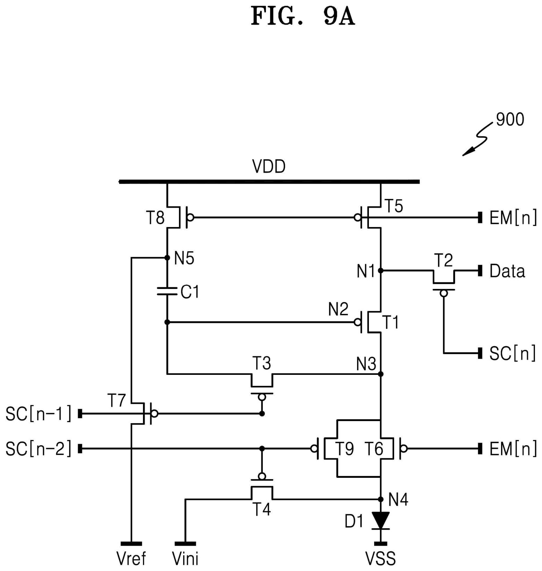

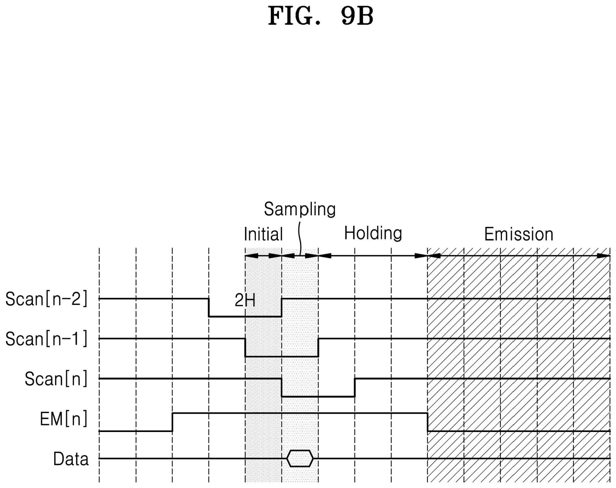

FIG. 9A illustrates a pixel circuit 900 according to an embodiment of the present disclosure, and FIG. 9B is an operation timing diagram of the pixel circuit 900 according to an embodiment of the present disclosure.

Referring to FIG. 9A, in an embodiment of the present disclosure, the pixel circuit 900 may include a light-emitting element D1, first, second, third, fourth, fifth, sixth, seventh, eighth, and ninth transistors T1, T2, T3, T4, T5, T6, T7, T8, and T9 and a storage capacitor C1. In an embodiment of the present disclosure, the first through ninth transistors T1 through T9 may be turned on or off in response to a first scan signal [n-2], a second scan signal [n-1], a third scan signal SC[n], and an emission signal EM[n].

Referring to FIG. 9B, in an embodiment of the present disclosure, the pixel circuit 900 may operate in an initial period, a sampling period, and an emission period. In an embodiment of the present disclosure, a holding period may be added between the sampling period and the emission period.

These operation periods may be distinguished from each other by the first, second, and third scan signals SC[n-2], SC[n-1], and SC[n] or the emission signal EM[n].

In an embodiment of the present disclosure, in the initial period, the first scan signal SC[n-2] and the second scan signal SC[n-1] may each be a first value for turning on a transistor. The fourth transistor T4 and the ninth transistor T9 may be turned on in response to the first scan signal SC[n-2] being the first value, and the third transistor T3 and the seventh transistor T7 may be turned on in response to the second scan signal SC[n-1] being the first value.

In an embodiment of the present disclosure, in the sampling period, the second scan signal SC[n-1] and the third scan signal SC[n] may each be a first value for turning on a transistor. The third transistor T3 and the seventh transistor T7 may be turned on in response to the second scan signal SC[n-1] being the first value, and the second transistor T2 may be turned on in response to the third scan signal SC[n] being the first value.

In an embodiment of the present disclosure, in the emission period, the first, second, and third scan signals SC[n-2], SC[n-1], and SC[n] may each be a second value for turning off a transistor, and the emission signal EM[n] may be a first value for turning on a transistor. The fifth transistor T5, the sixth transistor T6, and the eighth transistor T8 may be turned on in response to the emission signal EM[n] being the first value.

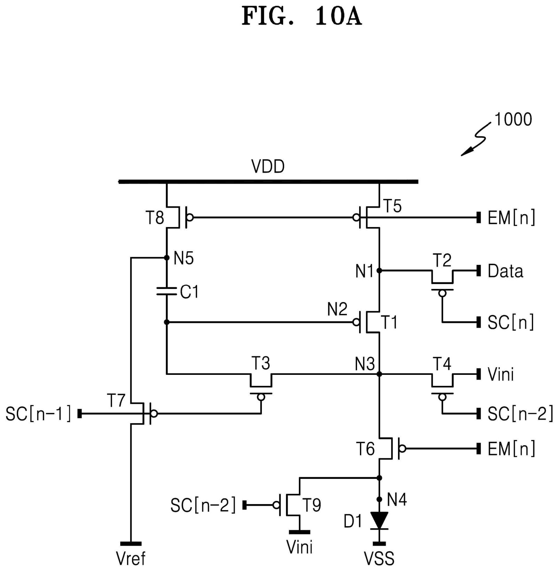

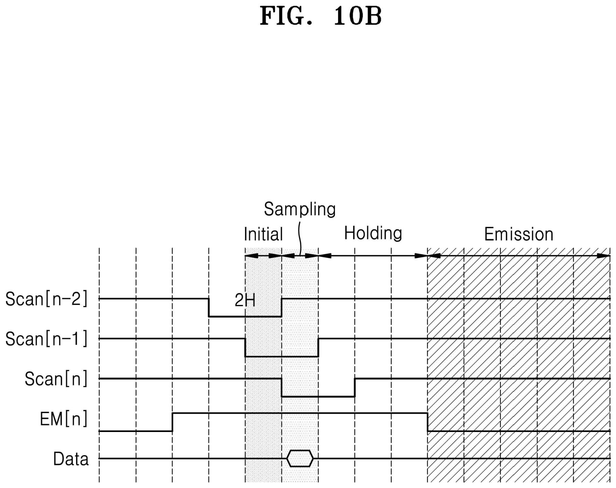

FIG. 10A illustrates a pixel circuit 1000 according to an embodiment of the present disclosure, and FIG. 10B is an operation timing diagram of the pixel circuit 1000 according to an embodiment of the present disclosure.

Referring to FIG. 10A, in an embodiment of the present disclosure, the pixel circuit 1000 may include a light-emitting element D1, first, second, third, fourth, fifth, sixth, seventh, eighth, and ninth transistors T1, T2, T3, T4, T5, T6, T7, T8, and T9 and a storage capacitor C1. In an embodiment of the present disclosure, the first through ninth transistors T1 through T9 may be turned on or off in response to a first scan signal [n-2], a second scan signal [n-1], a third scan signal SC[n], and an emission signal EM[n].

Referring to FIG. 10B, in an embodiment of the present disclosure, the pixel circuit 1000 may operate in an initial period, a sampling period, and an emission period. In an embodiment of the present disclosure, a holding period may be added between the sampling period and the emission period.

These operation periods may be distinguished from each other by the first, second, and third scan signals SC[n-2], SC[n-1], and SC[n] or the emission signal EM[n].

In an embodiment of the present disclosure, in the initial period, the first scan signal SC[n-2] and the second scan signal SC[n-1] may be a first value for turning on a transistor. The fourth transistor T4 and the ninth transistor T9 may be turned on in response to the first scan signal SC[n-2] being the first value, and the third transistor T3 and the seventh transistor T7 may be turned on in response to the second scan signal SC[n-1] being the first value.

In an embodiment of the present disclosure, in the sampling period, the second scan signal SC[n-1] and the third scan signal SC[n] may each be a first value for turning on a transistor. The third transistor T3 and the seventh transistor T7 may be turned on in response to the second scan signal SC[n-1] being the first value, and the second transistor T2 may be turned on in response to the third scan signal SC[n] being the first value.

In an embodiment of the present disclosure, in the emission period, the first, second, and third scan signals SC[n-2], SC[n-1], and SC[n] may each be a second value for turning off a transistor, and the emission signal EM[n] may be a first value for turning on a transistor. The fifth transistor T5, the sixth transistor T6, and the eighth transistor T8 may be turned on in response to the emission signal EM[n] being the first value.

A display panel according to an embodiment of the present disclosure may include a light-emitting element, a first transistor configured to control a current flowing through the light-emitting element, a storage capacitor connected to a gate of the first transistor, a second transistor connected to a first terminal of the first transistor and configured to apply a data signal, a third transistor connected to the gate of the first transistor and a second terminal of the first transistor, a fourth transistor connected to the second terminal of the first transistor and configured to apply an initialization voltage, a fifth transistor connected to the first terminal of the first transistor and configured to apply a first voltage, a sixth transistor connected to the second terminal of the first transistor and the light-emitting element, a seventh transistor connected to a first terminal of the storage capacitor and configured to apply a reference voltage, and an eighth transistor connected to the first terminal of the storage capacitor and configured to apply the first voltage.

In an embodiment of the present disclosure, the display panel may further include a scan driver configured to generate a first scan signal for turning on or off the fourth transistor, a second scan signal for turning on or off the third transistor and the seventh transistor, and a third scan signal for turning on or off the second transistor.

In an embodiment of the present disclosure, the first, second, and third scan signals may each have a first value for turning on a corresponding transistor for at least 2H (horizontal time).

In an embodiment of the present disclosure, the display panel further include an emission driver configured to generate an emission signal for turning on or off the fifth transistor, the sixth transistor, and the eighth transistor.

In an embodiment of the present disclosure, the display panel may further include an emission driver configured to generate a first emission signal for turning on or off the fifth transistor and the eighth transistor, and a second emission signal for turning on or off the sixth transistor.

In an embodiment of the present disclosure, in a first operation period, the third transistor, the fourth transistor, and the seventh transistor may be turned on, the initialization voltage may be applied to the gate of the first transistor, the reference voltage may be applied to the first terminal of the storage capacitor, and a third voltage determined based on the initialization voltage and a threshold voltage of the first transistor may be applied to the first terminal of the first transistor.

In an embodiment of the present disclosure, in a second operation period, the second transistor, the third transistor, and the seventh transistor may be are turned on, the data signal may be applied to the first terminal of the first transistor, and a fourth voltage determined based on the data signal and the threshold voltage of the first transistor may be applied to the gate of the first transistor.

In an embodiment of the present disclosure, in a third operation period, the fifth transistor, the sixth transistor, and the eighth transistor may be turned on, the first voltage may be applied to the first terminal of the storage capacitor, and a fifth voltage proportional to a variation in a voltage of the first terminal of the storage capacitor may be additionally applied to the gate of the first transistor.

In an embodiment of the present disclosure, the first operation period and the second operation period may be maintained for at least 1H. In an embodiment of the present disclosure, the first through eighth transistors may be any one of a low-temperature polycrystalline silicon thin-film transistor (LTPS TFT), an oxide thin-film transistor (TFT), a low-temperature polycrystalline oxide (LTPO), or a silicon-based switching element.

A display device according to an embodiment of the present disclosure may include an active area including a plurality of pixels arranged in rows and columns, a scan driver configured to apply a plurality of scan signals to the active area, an emission driver configured to apply a plurality of emission signals to the active area, a display driver integrated circuit (IC) configured to obtain image data, generate a plurality of data signals based on the image data, and apply the plurality of data signals to the active area, and a power supply configured to supply a first voltage, a second voltage, an initialization voltage, and a reference voltage to the active area.

In an embodiment of the present disclosure, each of the plurality of pixels may include a light-emitting element, a first transistor configured to control a current flowing through the light-emitting element, a storage capacitor connected to a gate of the first transistor, a second transistor connected to a first terminal of the first transistor and configured to apply a corresponding data signal, a third transistor connected to the gate of the first transistor and a second terminal of the first transistor, a fourth transistor connected to the second terminal of the first transistor and configured to apply the initialization voltage, a fifth transistor connected to the first terminal of the first transistor and configured to apply the first voltage, a sixth transistor connected to the second terminal of the first transistor and the light-emitting element, a seventh transistor connected to a first terminal of the storage capacitor and configured to apply the reference voltage, and an eighth transistor connected to the first terminal of the storage capacitor and configured to apply the first voltage.

In an embodiment of the present disclosure, the plurality of scan signals may include a first scan signal for turning on or off the fourth transistor, a second scan signal for turning on or off the third transistor and the seventh transistor, and a third scan signal for turning on or off the second transistor.

In an embodiment of the present disclosure, the first, second, and third scan signals may each have a first value for turning on a corresponding transistor for at least 2H (horizontal time).

In an embodiment of the present disclosure, in a first operation period, the third transistor, the fourth transistor, and the seventh transistor may be turned on, the initialization voltage may be applied to the gate of the first transistor, the reference voltage may be applied to the first terminal of the storage capacitor, and a third voltage determined based on the initialization voltage and a threshold voltage of the first transistor may be applied to the first terminal of the first transistor.

In an embodiment of the present disclosure, in a second operation period, the second transistor, the third transistor, and the seventh transistor may be are turned on, the corresponding data signal may be applied to the first terminal of the first transistor, and a fourth voltage determined based on the corresponding data signal and the threshold voltage of the first transistor may be applied to the gate of the first transistor.

In an embodiment of the present disclosure, in a third operation period, the fifth transistor, the sixth transistor, and the eighth transistor may be turned on, the first voltage may be applied to the first terminal of the storage capacitor, and a fifth voltage proportional to a variation in a voltage of the first terminal of the storage capacitor may be additionally applied to the gate of the first transistor.

## Claims

1. A display panel (100) comprising:
a light-emitting element (D1);
a first transistor (T1) configured to control current flowing through the light-emitting element (D1);
a storage capacitor (C1) connected to a gate of the first transistor (T1); a second transistor (T2) connected to a first terminal of the first transistor (T1) and configured to apply a data signal (Vdata);
a third transistor (T3) connected to the gate of the first transistor (T1) and a second terminal of the first transistor (T1);
a fourth transistor (T4) connected to the second terminal of the first transistor (T1) and configured to apply an initialization voltage (Vini);
a fifth transistor (T5) connected to the first terminal of the first transistor (T1) and configured to apply a first voltage (VDD);
a sixth transistor (T6) connected to the second terminal of the first transistor (T1) and the light-emitting element (D1);
a seventh transistor (T7) connected to a first terminal of the storage capacitor (C1) and configured to apply a reference voltage (Vref); and
an eighth transistor (T8) connected to the first terminal of the storage capacitor (C1) and configured to apply the first voltage (VDD).

2. The display panel (100) of claim 1, further comprising
a scan driver (120) configured to generate: a first scan signal (SC[n-2]) for turning on or off the fourth transistor (T4);
a second scan signal (SC[n-1]) for turning on or off the third transistor (T3) and the seventh transistor (T7); and
a third scan signal (SC[n]) for turning on or off the second transistor (T2).

3. The display panel (100) of claim 1 or 2, wherein
the first, second, and third scan signals (SC[n-2], SC[n-1], SC[n]) each have a first value for turning on a corresponding transistor for at least 2H (horizontal time).

4. The display panel (100) of any one of claims 1 through 3, further comprising
an emission driver (130) configured to generate an emission signal (EM[n]) for turning on or off the fifth transistor (T5), the sixth transistor (T6), and the eighth transistor (T8).

5. The display panel (100) of any one of claims 1 through 3, further comprising
an emission driver (130) configured to generate: a first emission signal (EM[n-1]) for turning on or off the fifth transistor (T5) and the eighth transistor (T8); and
a second emission signal (EM[n]) for turning on or off the sixth transistor (T6).

6. The display panel (100) of any one of claims 1 through 5, wherein,
in a first operation period,
the third transistor (T3), the fourth transistor (T4), and the seventh transistor (T7) are turned on,
the initialization voltage (Vini) is applied to the gate of the first transistor (T1),
the reference voltage (Vref) is applied to the first terminal of the storage capacitor (C1), and
a third voltage determined based on the initialization voltage (Vini) and a threshold voltage of the first transistor (T1) is applied to the first terminal of the first transistor (T1).

7. The display panel (100) of any one of claims 1 through 6, wherein
in a second operation period,
the second transistor (T2), the third transistor (T3), and the seventh transistor (T7) are turned on,
the data signal (Vdata) is applied to the first terminal of the first transistor (T1), and
a fourth voltage determined based on the data signal (Vdata) and the threshold voltage of the first transistor (T1) is applied to the gate of the first transistor (T1).

8. The display panel (100) of any one of claims 1 through 7, wherein
in a third operation period,
the fifth transistor (T5), the sixth transistor (T6), and the eighth transistor (T8) are turned on,
the first voltage (VDD) is applied to the first terminal of the storage capacitor (C1), and
a fifth voltage proportional to a variation in voltage of the first terminal of the storage capacitor (C1) is additionally applied to the gate of the first transistor (T1).

9. The display panel (100) of any one of claims 1 through 8, wherein
the first operation period and the second operation period are maintained for at least 1H (horizontal time).

10. The display panel (100) of any one of claims 1 through 9, wherein
the first through eighth transistors (T_1 through T_8) each are any one of a low-temperature polycrystalline silicon thin-film transistor (LTPS TFT), an oxide thin-film transistor (TFT), a low-temperature polycrystalline oxide (LTPO), or a silicon-based switching element.

11. A display device comprising:
an active area (150) including a plurality of pixels (151) arranged in rows and columns;
a scan driver (120) configured to apply a plurality of scan signals to the active area (150);
an emission driver (130) configured to apply a plurality of emission signals to the active area (150);
a display driver integrated circuit (IC) (110) configured to obtain image data, generate a plurality of data signals based on the image data, and apply the plurality of data signals to the active area (150); and
a power supply (140) configured to supply a first voltage (VDD), a second voltage (VSS), an initialization voltage (Vini), and a reference voltage (Vref) to the active area (150),
wherein each of the plurality of pixels (151) comprises:
a light-emitting element (D1);
a first transistor (T1) configured to apply control a current flowing through the light-emitting element (D1);
a storage capacitor (C1) connected to a gate of the first transistor (T1); a second transistor (T2) connected to a first terminal of the first transistor (T1) and configured to apply a corresponding data signal (Vdata);
a third transistor (T3) connected to the gate of the first transistor (T1) and a second terminal of the first transistor (T1);
a fourth transistor (T4) connected to the second terminal of the first transistor (T1) and configured to apply the initialization voltage (Vini);
a fifth transistor (T5) connected to the first terminal of the first transistor (T1) and configured to apply the first voltage (VDD);
a sixth transistor (T6) connected to the second terminal of the first transistor (T1) and the light-emitting element (D1);
a seventh transistor (T7) connected to a first terminal of the storage capacitor (C1) and configured to apply the reference voltage (Vref); and
an eighth transistor (T8) connected to the first terminal of the storage capacitor (C1) and configured to apply the first voltage (VDD).

12. The display device of claim 11, wherein
the plurality of scan signals comprise:
a first scan signal (SC[n-2]) for turning on or off the fourth transistor (T4);
a second scan signal (SC[n-1]) for turning on or off the third transistor (T3) and the seventh transistor (T7); and
a third scan signal (SC[n]) for turning on or off the second transistor (T2), and
the first, second, and third scan signals (SC[n-2], SC[n-1], SC[n]) each have a first value for turning on a corresponding transistor for at least 2H (horizontal time).

13. The display device of claim 11 or 12, wherein
in a first operation period,
the third transistor (T3), the fourth transistor (T4), and the seventh transistor (T7) are turned on,
the initialization voltage (Vini) is applied to the gate of the first transistor (T1),
the reference voltage (Vref) is applied to the first terminal of the storage capacitor (C1), and
a third voltage determined based on the initialization voltage (Vini) and a threshold voltage of the first transistor (T1) is applied to the first terminal of the first transistor (T1).

14. The display device of any one of claims 11 through 13, wherein
in a second operation period,
the second transistor (T2), the third transistor (T3), and the seventh transistor (T7) are turned on,
the corresponding data signal (Vdata) is applied to the first terminal of the first transistor (T1), and
a fourth voltage determined based on the corresponding data signal (Vdata) and the threshold voltage of the first transistor (T1) is applied to the gate of the first transistor (T1).

15. The display device of any one of claims 11 through 14, wherein
in a third operation period,
the fifth transistor (T5), the sixth transistor (T6), and the eighth transistor (T8) are turned on,
the first voltage (VDD) is applied to the first terminal of the storage capacitor (C1), and
a fifth voltage proportional to a variation in voltage of the first terminal of the storage capacitor (C1) is additionally applied to the gate of the first transistor (T1).
